# EUROPÄISCHE PATENTSCHRIFT

(11) **EP 0 962 748 B1**
(45) Veröffentlichungstag und Bekanntmachung des Hinweises auf die Patenterteilung: **16.08.2001**
(21) Anmeldenummer: 99106806.5
(22) Anmeldetag: 06.04.1999
(51) Int. Cl.: G01D 3/08, G01R 31/28, G01P 21/02

(54) **Verfahren und Vorrichtung zur Funktionsüberwachung eines Sensorbausteins**
Method and circuit for monitoring the functioning of a sensor module
Procédé et circuit pour la surveillance du fonctionnement d'un module de détection

(30) Priorität: 30.05.1998 DE 19824362
(43) Veröffentlichungstag der Anmeldung: 08.12.1999
(73) Patentinhaber: Micronas GmbH, 79108 Freiburg (DE)
(72) Erfinder: Blossfeld, Lothar Dipl.-Ing., 79874 Breitnau (DE); Janke, Ralf Dipl.-Ing., 79194 Gundelfingen (DE)
(74) Vertreter: Patent- und Rechtsanwaltssozietät, Maucher, Börjes & Kollegen

(56) Entgegenhaltungen:
- DE-A- 3 829 875
- DE-A- 19 510 416
- US-A- 5 495 112
- PATENT ABSTRACTS OF JAPAN vol. 018, no. 088 (E-1507), 14. Februar 1994 (1994-02-14) & JP 05 292571 A (TOSHIBA CORP), 5. November 1993 (1993-11-05)

## Beschreibung

Die Erfindung bezieht sich auf ein Verfahren zur Funktionsüberwachung eines Sensorbausteins, der als monolithisch integrierte Schaltung ausgebildet ist und einen Sensor sowie zumindest einen Meßverstärker aufweist, wobei der Sensorbaustein Außenanschlüsse zumindest zur Stromversorgung und für ein Ausgangsmeßsignal hat und wobei über einen vorhandenen Anschluß zusätzlich zu der Meßgröße eine Zusatzmeßgröße ausgegeben wird.

Bei dem dabei verwendeten Sensorbaustein kann es sich insbesondere um einen Baustein mit einem magnetfeldabhängigen Sensor handeln, allerdings sind auch Sensorbausteine mit anderen Sensoren, beispielsweise einem optischen Sensor, einem Drucksensor und dergleichen verwendbar.
Sensorbaustein mit Magnetfeldsensoren (zum Beispiel mit einem Hall-Sensor) werden unter anderem im Kraftfahrzeugsektor in Nocken/Kurbelwellenapplikationen oder in ABS-Systemen eingesetzt. Die Drehbewegung bei diesen Systemen führt zum Beispiel durch eine Kombination von drehendem Zahnrad und ortsfesten Magneten am Ort des Sensors zu einem Magnetsignal, welches aus einem Gleichspannungs- und einem Wechselspannungsanteil besteht. Durch die Messung des Wechselspannungsanteils, welcher mit statischen differenziellen Sensoren mit zwei magnetsensitiven Flächen oder dynamischen Sensoren mit einer magnetsensitiven Fläche erfolgt, wird die Drehbewegung beispielsweise durch den Halleffekt in eine Spannung umgesetzt, die bei einem Sensorbaustein mit digitalem Ausgangsmeßsignal durch eine Schmitt-Trigger-Schaltung zu einem Schalten am Ausgang des Sensorbausteins führt.
In Abhängigkeit von der Umgebungstemperatur des Sensorbausteins, der beispielsweise im Motorraum eines Kraftfahrzeugs eingebaut sein kann, können sich die Abstände Zahnrad-Magnetsensor-Magnet verändern, so daß sowohl der AC- als auch der DC-Anteil des Magnetfeldes am Ort des Magnetsensors verändert wird. Dies kann auch durch Verschleiß einer mechanischen Komponente im Laufe der Betriebszeit eintreten. Diese durch äußere Umstände bedingte Abnahme des Wechselspannungsanteil kann zu einem plötzlichen Ausfall der Funktion der Applikation führen, wenn zum Beispiel bei einem Sensorbaustein mit digitalem Ausgang ein bestimmter Schwellwert unterschritten wird.
Ein solcher Ausfall des Systems kann beispielsweise im Motormanagement erheblich sachliche Schäden und ebenso Sicherheitsprobleme zur Folge haben. Die Funktion des Sensors selbst in seinen Parametern ist in solchen Fällen nicht die Ursache für einen Ausfall, sondern die sich in der Umgebung des Sensors ändernden Umgebungsbedingungen. Die Möglichkeit der Funktionsüberwachung beschränkt sich somit auf die Kontrolle des Ausgangsmeßsignales und dabei auf dessen Vorhandensein bei einem Sensoreingangssignal.

Aus der US 5 495 112 ist ein Flammendetektor mit Selbstdiagnosesystem bekannt, bei dem ein optisches Kontrollsignal erzeugt wird, das in einem Kontrollkreis zusätzlich zu dem Flammensignal eingangsseitig eingekoppelt und ausgangsseitig ausgewertet wird.
Der Kontrollkreis, in den praktisch alle Funktionsgruppen des Detektors einbezogen sind, ist vorgesehen, um eine eindeutige Auswertung des Ausgangssignales zu erreichen. Liegt am Ausgang das Kontrollsignal an, jedoch kein Flammenausgangssignal, so kann davon ausgegangen werden, daß die Schaltung funktioniert und die Flamme tatsächlich aus ist.
Aus der DE 38 29 875 ist eine Schaltungsanordnung zur Überwachung eines induktiven Sensors bekannt. Die vom Sensor erzeugte Wechselspannung durchläuft zwei voneinander getrennte Zweige der Auswerteschaltung, wobei in einem Zweig eine Frequenzauswertung als eigentliches Nutzsignal und im anderen Zweig entweder eine Amplitudenauswertung erfolyt oder eine frequenzproportionale Spannung erzeugt wird.
Auch hiermit läßt sich die Gesamtfunktion der Schaltung überwachen, so daß Fehlinterpretationen des Nutzsignales vermieden werden.

Den beiden zum Stand der Technik gehörenden Druckschriften US 5 495 112 und DE 38 29 875 ist gemeinsam, daß zwar eine Überwachung der Gesamtfunktion vorhanden ist, jedoch ein Totalausfall der Schaltung nicht rechtzeitig vor dem Eintreten dieses Ereignisses feststellbar ist.

Aufgabe der vorliegenden Erfindung ist es, ein Verfahren zur Funktionsüberwachung eines Sensorbausteins sowie einen dafür geeigneten Sensorbaustein zu schaffen, womit eine erweiterte Funktionsüberwachung möglich ist, die auch sich ändernde Umgebungsbedingungen erkennen läßt, so daß rechtzeitig vor dem Funktionsausfall Gegenmaßnahmen getroffen werden können. Dabei soll der Aufwand für den Sensorbaustein praktisch unverändert bleiben und auch dessen jeweils vorgebene Bauform soll beibehalten bleiben.

Zur Lösung dieser Aufgabe wird hinsichtlich des Verfahrens vorgeschlagen, daß innerhalb des Sensorbausteins zur Verfügung stehende Schaltungsmeßwerte als Modulationssignale dem Versorgungstrom und/oder der Versorgungsspannung und/oder dem Ausgangmeßsignal überlagert und über die vorhandenen Außenanschlüsse als Diagnosesignale ausgegeben werden und daß entweder die internen Schaltungsmeßwerte als analoge oder digitale Modulation und das Ausgangmeßsignal als digitaler Wert oder die internen Schaltungsmeßwerte als digitale Modulation und das Ausgangsmeßsignal als analoger Wert ausgegeben werden.
Anhand der internen Schaltungsmeßwerte kann hier vor einem Ausfall der Sensorfunktion, d.h. bevor das Ausgangsmeßsignal nicht mehr auswertbar beziehungsweise nicht mehr vorhanden ist, tendentiell rechtzeitig davor erkannt werden, daß sich die Meßbedingungen des Sensorbausteins geändert haben. Die internen Schaltungsmeßwerte, die sich ändernde Umgebungsbedingungen erkennen lassen, werden als Modulation beispielsweise dem Ausgangsmeßsignal überlagert. Nach außen hin steht somit ein entsprechendes Diagnosesignal zur Verfügung. Durch die Modulation des Ausgangsignales, wahlweise auch des Versorgungsstromes oder der Versorgungsspannung, bleiben die Funktionswerte unverändert, so daß keine Unterbrechung der Meßfunktion beziehungsweise des Ausgangsmeßsignales vorhanden ist. Vorteilhaft ist weiterhin, daß die vorhandenen Anschlüsse für die Ausgabe des Diagnosesignales mitverwendet werden können und somit die Bauform des Sensorbausteins und dessen Anschlußbelegung unverändert bleiben kann.
Zweckmäßigerweise wird bei einem digitalen Ausgangsmeßsignal zumindest ein zu den Sensorsignalen proportionaler Meßwert als Schaltungsmeßwert erfaßt und als Diagnosewert über die vorhandenen Außenanschlüsse ausgegeben. Das digitale Ausgangsmeßsignal steht nur zur Verfügung, wenn die Amplitude des Sensorsignales jeweils einen vorgegebenen Schwellwert überschreitet. Wird diese Schwellwert nicht erreicht, so werden dementsprechend keine Ausgangssignale mehr geliefert und ein plötzlicher Funktionsausfall ist die Folge. Da aber erfindungsgemäß schaltungsintern als Schaltungsmeßwert ein dem Sensorsignal proportionaler Meßwerterfaßt und als Diagnosesignal außen zur Verfügung steht, kann im vorliegenden Fall anhand einer sich ändernden Amplitude des Sensorsignals rechtzeitig vor dem Funktionsausfall die Gefahr erkannt und es können entsprechende Gegenmaßnahmen ergriffen werden.

Es besteht aber auch die Möglichkeit, daß bedarfsweise in Kombination mit der vorbeschriebenen Maßnahme als Schaltungsmeßwerte eine OffsetSpannung beziehungsweise der Offset-Strom, die Temperatur, Filterkoeffizienten und dergleichen interne Betriebsdaten der Schaltung erfaßt und als Diagnosesignal über die vorhandenen Außenanschlüsse ausgegeben werden. Auch an diesen internen Schaltungsmeßwerten können sich ändernde, äußere Umgebungsbedingungen erkannt werden.

Eine Weiterbildung des erfindungsgemäßen Verfahrens sieht vor, daß das Diagnosesignal von außen über die vorhandenen Außenanschlüsse insbesondere mittels eines über die vorhandenen Außenanschlüsse zuführbaren Abruf-Modulationssignals abgerufen wird. In vielen Anwendungsfällen sind Änderungen von Umgebungsbedingungen nur in längeren Zeitabschnitten zur erwarten, so daß es hierbei genügt, in vorgegebenen Zeitabständen Diagnosewerte abzurufen.

Die Erfindung bezieht auch auf einen Sensorbaustein, der als monolithisch integrierte Schaltung ausgebildet ist und einen Sensor sowie zumindest einen Meßverstärker ausweist, wobei der Sensorbaustein Außenanschlüsse zumindest zur Stromversorgung und für das Ausgangsmeßsignal hat und wobei ein vorhandener Anschluß zur Ausgabe einer zusätzlichen Meßgröße dient.
Dieser Sensorbaustein ist erfindungsgemäß dadurch gekennzeichnet, daß in dem Sensorbaustein eine Auswerteschaltung vorgesehen ist, die an wenigstens eine interne Meßstelle der Schaltung angeschlossen ist, daß die Auswerteschaltung mit einem Modulator zur Modulation des Versorgungsstroms und/oder der Versorgungsspannung und/oder des Ausgangsmeßsignals verbunden ist, zur Ausgabe eines aus einem internen Schaltungsmeßwert gebildeten Diagnosesignales über die vorhandenen Außenanschlüsse des Sensorbaustein und daß die Auswerteschaltung und dergleichen Zusatzbaugruppen integraler Bestandteil der monolithisch integrierten Schaltung ist.
Wie bereits in Verbindung mit dem erfindungsgemäßen Verfahren erläutert, ist bei diesem erfindungsgemäßen Sensorbaustein über die vorhandenen Außenanschlüsse außer dem Ausgangsmeßsignal auch ein Zugang zu internen Schaltungs-Meßstellen vorhanden und die dadurch zur Verfügung stehenden Meßwerte ermöglichen eine Diagnose der Funktion der Schaltung. Insbesondere ist dadurch erkennbar, mit welchem (Sicherheits-) Abstand die Schaltung von ihren Betriebsgrenzen gerade arbeitet. Daraus lassen sich rechtzeitig vor Ausfall der Betriebsfunktion passende Gegenmaßnahmen ergreifen. Durch das Aufmodulieren der Diagnosewerte auf vorhandene Meß- oder Versorgungsgrößen sind keine zusätzlichen Anschlüsse erforderlich, so daß die Bauform des Sensorbausteins und dessen Anschlußbelegung unverändert bleiben kann. In vorgegebenen Applikationen bisher eingesetzte Sensorbaustein können daher problemlos durch erfindungsgemäße Sensorbausteine ersetzt werden, ohne das schaltungsseitig Änderungen erforderlich sind.
Eine vorteilhafte Verwendung eines erfindungsgemäßen Sensorbausteines ist für eine Drehzahlmessung mit gleichzeitiger Abstandmessung des Sensors oder des Sensorbausteins von einem Geber vorhanden. Beispielsweise ist dadurch ein Einsatz bei einem Kraftfahrzeug möglich, das mit einem ABS-System ausgerüstet ist, wobei mit Magnetfeldsensoren die Umdrehungsgeschwindigkeit der Ränder gemessen wird. Die Drehung wird mit einem Zahnrad gemessen, welches die gleiche Rotationsgeschwindigkeit hat, wie das Rad selbst. Die Abnutzung der Brembeläge bewirkt, daß sich für die Bremzylinder im Laufe der Lebensdauer der Bremsbeläge größere Betätigungswege ergeben. Durch die Kopplung dieser Bewegung mit der Position des für die Drehzahlmessung vorgesehenen Sensors ist die Möglichkeit geschaffen, mit einem einzigen Sensor sowohl die Drehbewegung zu erfassen, als auch die Veränderung der Amplitude (Wechselspannungsanteil), die sich durch die Abstandsänderung bei mit der Zeit sich abnützenden Bremsbelägen einstellt.

Zusätzliche Ausgestaltungen der Erfindung sind in den weiteren alhängigen Patentansprüchen ausgeführt. Nachstehend ist die Erfindung mit ihren wesentlichen Einzelheiten anhand der Zeichnungen noch näher erläutert. Es zeigt:
- Fig.1: eine schematische Darstellung eines Sensorbausteins mit Funktionsblöcken und
- Fig.2 bis 4: Diagramme des Ausgangsmeßsignales mit unterschiedlich aufmodulierten Diagnosesignalen.

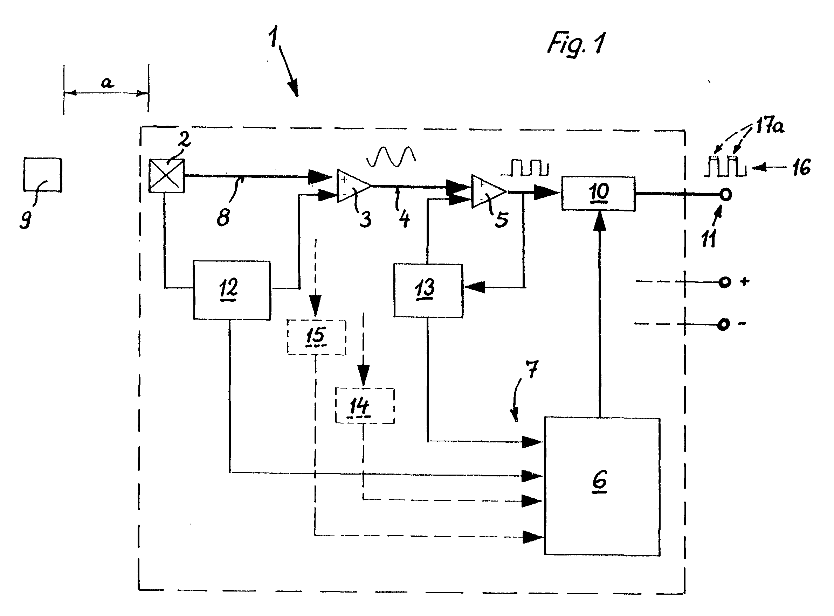

Ein in Fig.1 in Blockdarstellung gezeigter Sensorbaustein 1 dient zur Messung beziehungsweise Erfassung magnetischer Felder und weist dazu einen Magnetfeldsensor 2 auf. Dieser Magnetfeldsensor ist an einen Meßverstärker 3 angeschlossen, an dessen Ausgang 4 ein zu dem Sensorsignal proportionaler, verstärkter Meßwert ansteht. Über einen dem Meßverstärker nachgeordneten Schmitt-Trigger 5 erfolgt eine Signalformung und Digitalisierung des verstärktes Meßsignales. Dieses Ausgangsignal des Schmitt-Triggers 5 bildete bei bisherigen, digitalen Sensorbausteinen das Ausgangsmeßsignal.
Der Schmitt-Trigger 5 schaltet beim Überschreiten und Unterschreiten eines bestimmten Eingangsspannungspegel von einem stabilen Zustand in den anderen. Ändert sich nun am Ausgang 4 des Meßverstärkers 3 die Amplitude des Wechselspannungsanteils der dort anstehenden Spannung und damit der Eingangsspannung des Schmitt-Triggers 5, so liefert dieser bei Unterschreiten eines vorgegebenen Schwellwertes kein Ausgangssignal mehr.
Um diesen plötzlichen Ausfall der Funktion vorhersehbar zu machen, ist der erfindungsgemäße Sensorbaustein 1 mit einer Auswerteschaltung 6 versehen, die an einen oder mehrere interne Meßstellen der Schaltung angeschlossen ist. Unter anderem besteht die Möglichkeit, daß ein solcher Meßeingang 7 an den einen analogen Schaltungsmeßwert liefernden Sensorausgang 8 oder an den Ausgang 4 des Meßverstärkers 3 angeschlossen ist. Mit der Auswerteschaltung 6 kann dann erfaßt werden, daß sich beispielsweise bei einer Änderung des Abstandes a zu einem externen Geber 9, der Wechselspannungsanteil des am Sensorausgang 8 oder Verstärkerausgang 4 anstehenden Meßsignales abgenommen hat. Diese Information steht unmittelbar zur Verfügung, wenn eine Änderung der Umgebungsbedingungen, beispielsweise des Abstandes a zwischen Geber 9 und Magnetfeldsensor 2 eingetreten ist. Somit kann rechtzeitig vor dem Erreichen der Arbeitsgrenzen des Schmitt-Triggers reagiert werden und es können Gegenmaßnahmen ergriffen werden, um einem plötzlichen Ausfall des Systems vorzubeugen. Am Ausgang des Schmitt-Triggers 5 würden innerhalb seiner Arbeitsgrenzen diese Änderungen des Eingangssignales nicht erkennbar sein.
Um die in der Auswerteschaltung 6 zur Verfügung stehenden Informationen nach außen zu bringen, werden die intern erfaßten Meßwerte als Modulationssignale an einen Modulator 10 gegeben, der diese im vorliegenden Fall dem Ausgangsmeßsignal des Schmitt-Triggers 5 überlagert. An dem Außenanschluß 11 für das Ausgangsmeßsignal steht dann gleichzeitig auch ein überlagertes Diagnosesignal an, das einen Rückschluß auf den momentanen Arbeitspunkt der Schaltung zuläßt.
Die Meßeingänge 7 der Auswerteschaltung 6 können mit den verschiedensten, internen Meßstellen der Schaltung verbunden sein. Im vorliegenden Ausführungsbeispiel (Fig.1) ist zwischen dem Magnetfeldsensor 2 und dem Meßverstärker 3 eine Offset-Kompensationseinrichtung 12 geschaltet, an der als Schaltungsmeßwert die OffsetSpannung beziehungsweise der Offset-Strom abgegriffen und der Auswerteschaltung 6 zugeführt wird. Die Überwachung der Offset-Kompensation läßt Rückschlüsse auf die interne Funktionssituation der Schaltung zu. Gleiches gilt für die Überwachung eines Filterkreises mit einem Filter 13, an das die Auswerteschaltung 6 angeschlossen ist, so daß als interne Betriebsdaten beispielsweise die Filterkoeffizienten erfaßt werden können.
Dies sind nur Beispiele für interne Meßstellen, an die die Auswerteschaltung 6 angeschlossen sein kann. Strichliniert ist angedeutet, daß auch noch weitere Meßstellen, beispielsweise eine Druckmeßstelle 14, eine Temperaturmeßstelle 15 an die Auswerteschaltung 6 angeschlossen sein können. Die von der Druckmeßstelle 14 gelieferten Meßdaten können beispielsweise für die Art des Einbaus des Sensorbausteins von Bedeutung sein, weil dieser Meßwert eine Aussage darüber gibt, ob die Einbaulage und die Einbauart des Sensorbausteins die Funktion der Schaltung nachteilig beeinflußt.
In jedem Falle können über die Diagnosesignale Informationen ausgegeben werden, die Rückschlüsse auf den momentanen Arbeitspunkt der Schaltung zulassen. Änderungen, die sich in Richtung Betriebsgrenzen des Sensorbausteines bewegen, können so rechtzeitig ausgewertet werden, bevor ein Totalausfall des Sensorbausteins erfolgt. Die Ursache für einen solchen Totalausfall ist in der Regel in der Umgebung des Sensors durch sich ändernde Umgebungsbedingungen zu suchen, beispielsweise durch Vergrößerung des Abstandes zwischen dem Magnetfeldsensor 2 und einem Geber 9.

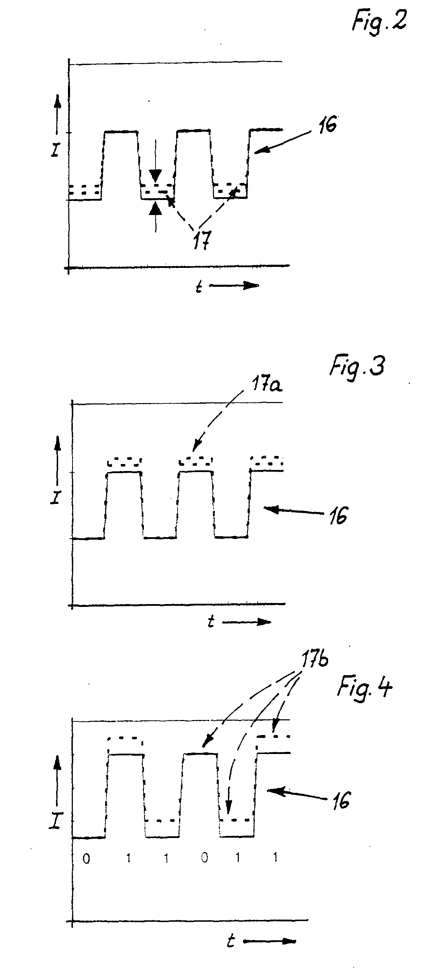

Die Fig.2 bis 4 zeigen in Diagrammen digitale Ausgangsmeßsignale 16, wie sie am Außenanschluß 11 des in Fig.1 gezeigten Sensorbausteins 1 anstehen können. Anhand der Fig.2 bis 4 sind anhand unterschiedliche Modulationsarten Möglichkeiten gezeigt, wie Diagnosesignale 17 dem Ausgangsmeßsignal 16 überlagert werden können. Wesentlich ist hierbei auch, daß der Informationsinhalt des Ausgangsmeßsignales 16 bei der Überlagung mit dem Diagnosesignal 17 unverändert bleibt und kontinuierlich zur Verfügung steht.
In den drei Diagrammen gemäß Fig.2 bis 4 ist auf der Abszisse die Zeit und auf der Ordinate die Stromaufnahme aufgetragen. Es handelt sich bei dem entsprechenden Sensorbaustein um einen solchen mit einem Stromausgang. Bei einem Sensor mit Spannungsausgang wäre auf der Ordinate die Ausgangsspannung aufgetragen.
Das Ausgangsmeßsignal 16 ist ein Rechteckausgangssignal, bei dem der Strompegel zwischen "low" und "high" wechselt.
Gemäß Fig.2 ist eine analoge Ausgabe des Diagnosesignales durch eine Änderung des Low-Stromlevels vorgesehen. Die Abweichung des strichliniert mit zwei verschiedenen Werten eingezeichneten Diagnosesignales 17 von dem Low-Stromlevel als Bezugsgröße stellt eine proportionalen Diagnosewert dar, der einer bestimmten Meßfunktion zugeordnet ist. Beispielsweise kann dieser proportionale Diagnosewert einen zwischen dem Magnetfeldsensor 2 und einem Geber 9 vorhandenen Abstand a repräsentieren.

In dem in Fig.3 gezeigten Diagramm ist dem digitalen Ausgangmeßsignal 16 ein analoges Diagnosesignal 17a überlagert, wobei die proportionale Abweichung des High-Stromlevels den Diagnosewert repräsentiert.
Außer der analogen Ausgabe des Diagnosesignales kann auch eine digitale Ausgabe erfolgen, wie dies in Fig.4 dargestellt ist. Dem Ausgangmeßsignal 16 ist das Diagnosesignal 17b überlagert, wobei dieses durch eine Änderung der Low- und/oder High-Stromlevel erfolgt. Der in Fig.4 gezeigte Ausgangsmeßsignal-Abschnitt enthält als digitale Diagnoseinformation die binäre Sequenz 011011.
In dem gezeigten Ausführungsbeispiel erfolgt eine digitale Ausgabe des Ausgangsmeßsignales 16 und eine analoge (Fig.2 und 3) oder digitale Modulation (Fig.4) des Ausgangsmeßsignals. Es besteht aber auch die Möglichkeit, daß das Ausgangsmeßsignal als analoger Wert ausgeben wird und die Modulation digital erfolgt.
Die Ausgabe des Diagnosesignales kann darüberhinaus in den unterschiedlichsten Variationen erfolgen, wobei zwischen dem intern gemessenen Schaltungsmeßwert und dem nach außen gegebenen Diagnosesignal außer einem linearen Zusammenhang auch logarithmische oder andere, nichtlineare Funktionen vorgesehen sein können.

In Fig.1 ist ein Sensorbaustein 1 mit einem Drei-Pin-Gehäuse gezeigt, wobei das Ausgangsmeßsignal 16 und das diesem überlagerte Diagnosesignal an dem Pin 11 ansteht. Die beiden anderen Pins dienen der Stromversorgung des Sensorbaustein.
Die Erfindung läßt sich auch bei einem Zwei-Pin-Gehäuse realisieren, in dem das Ausgangsmeßsignal in den beiden Betriebszuständen "hohe Stromaufnahme" und "niedrige Stromaufnahme" enthalten ist. Die Ausgabe des Diagnosesignales erfolgt analog oder digital durch eine Änderung des High- und/oder des Low-Pegels, wie dies anhand der Fig.2 bis 4 beschrieben wurde.
Bei dem in Fig.1 gezeigten Sensorbaustein handelt es sich um eine monolithisch integrierte Schaltung, bei der die Auswerteschaltung 6 mit Modulator 10 und dergleichen integrale Bestandteile sind.

Außer der bereits vorerwähnten Verwendung des Sensorbausteins 1 für eine Drehzahlmessung mit gleichzeitiger Abstandsmessung des Sensors 2 von einem Geber 9, beispielsweise bei einem Kraftfahrzeug, wo die Drehzahl eines Rades erfaßt und gleichzeitig die Abnützung der Bremsbeläge überwacht wird, ist auch ein Einsatz für Nocken/Kurbelwellenapplikationen und ähnlichen Anwendungen möglich. In allen diesen Anwendungsfällen kann mit Hilfe des Diagnosesignales eine Veränderung und speziell eine Verschlechterung des AC-Anteils und des Quotienten AC/DC-Anteils gemessen werden. Durch eine entsprechende Beschaltung mit einem Controllerbaustein steht dann eine hilfreiche Aussage über die Leistungsfähigkeit und Funktionssituation des Systems zur Verfügung. Es kann zwar damit ein Verschleiß von mechanischen Komponenten nicht verhindert werden, jedoch besteht die Möglichkeit, einen plötzlichen Ausfall des Sensors beispielsweise anhand der Messung des magnetischen AC-Anteils rechtzeitig vorherzusehen, um dann vor einem Ausfall entsprechende Maßnahmen zu veranlassen.

## Patentansprüche

1. Verfahren zur Funktionsüberwachung eines Sensorbausteins, der einen Sensor sowie zumindest einen Meßverstärker aufweist, wobei der Sensorbaustein Außenanschlüsse zumindest zur Stromversorgung und für ein Ausgangsmeßsignal hat und wobei über einen vorhandenen Anschluß zusätzlich zu der Meßgröße eine Zusatzmeßgröße ausgegeben wird, **dadurch gekennzeichnet,** daß der Sensorbaustein als monolitisch intergrierte Schaltung ausgebildet ist, innerhalb des Sensorbausteins zur Verfügung stehende Schaltungsmeßwerte als Modulationssignale dem Versorgungsstrom und/oder der Versorgungsspannung und/oder dem Ausgangsmeßsignal (16) überlagert und über die vorhandenen Außenanschlüsse als Diagnosesignale (17,17a,17b) ausgegeben werden und daß entweder die internen Schaltungsmeßwerte als analoge oder digitale Modulation und das Ausgangsmeßsignal als digitaler Wert oder die internen Schaltungsmeßwerte als digitale Modulation und das Ausgangsmeßsignal als analoger Wert ausgegeben werden.

2. Verfahren nach Anspruch 1, dadurch gekennzeichnet, daß bei einem digitalen Ausgangsmeßsignal (16) zumindest ein zu den Sensorsignalen proportionaler Meßwert als Schaltungsmeßwert erfaßt und als Diagnosesignal über die vorhandenen Außenanschlüsse ausgegeben wird.

3. Verfahren nach Anspruch 1 oder 2, dadurch gekennzeichnet, daß als Schaltungsmeßwerte die Offsetspannung beziehungsweise der Offsetstrom, die Temperatur, Filterkoeffizienten und dergleichen interne Betriebsdaten der Schaltung erfaßt und als Diagnosesignal über die vorhandenen Außenanschlüsse ausgegeben werden.

4. Verfahren nach einem der Ansprüche 1 bis 3, dadurch gekennzeichnet, daß das Diagnosesignal von außen über die vorhandenen Außenanschlüsse insbesondere mittels eines über die vorhandenen Außenanschlüsse zuführbaren Abruf-Modulationssignals abgerufen wird.

5. Sensorbaustein, der als monolithisch integrierte Schaltung ausgebildet ist und einen Sensor sowie zumindest einen Meßverstärker aufweist, wobei der Sensorbaustein Außenanschlüsse zumindest zur Stromversorgung und für das Ausgangsmeßsignal hat und wobei ein vorhandener Anschluß zur Ausgabe einer zusätzlichen Meßgröße dient, zur Durchführung des Verfahrens nach einem der Ansprüche 1 bis 4, **dadurch gekennzeichnet,** daß in dem Sensorbaustein (1) eine Auswerteschaltung (6) vorgesehen ist, die an wenigstens eine interne Meßstelle der Schaltung angeschlossen ist, daß die Auswerteschaltung (6) mit einem Modulator (10) zur Modulation des Versorgungsstroms und/oder der Versorgungsspannung und/oder des Ausgangsmeßsignals verbunden ist zur Ausgabe eines aus einem internen Schaltungsmeßwert gebildeten Diagnosesignales (17,17a,17b) über die vorhandenen Außenanschlüsse (11) des Sensorbausteins und daß die Auswerteschaltung (6) und dergleichen Zusatzbaugruppen integraler Bestandteil der monolithisch integrierten Schaltung ist.

6. Sensorbaustein nach Anspruch 5, dadurch gekennzeichnet, daß er einen dem Meßverstärker (3) nachgeordneten Schmitt-Trigger (5) oder dergleichen Signalformer zur Bildung eines digitalen Ausgangsmeßsignals (16) aufweist und daß die Auswerteschaltung (6) an den einen analogen Schaltungsmeßwert liefernden Sensorausgang und/oder den nachgeschalteten Meßverstärker angeschlossen ist.

7. Sensorbaustein nach Anspruch 5 oder 6, dadurch gekennzeichnet, daß die Auswerteschaltung (6) schaltungsintern an eine Offset-Kompensationseinrichtung (12) und/oder an ein Filter (13) und/oder an einen Temperaturfühler angeschlossen ist.

8. Sensorbaustein nach einem der Ansprüche 5 bis 7, dadurch gekennzeichnet, daß das Diagnosesignal (17,17a,17b) von außen über die vorhandenen Außenanschlüsse abrufbar ist, insbesondere mittels eines über die vorhandenen Außenanschlüsse zuführbaren Abruf-Modulationssignals und daß die Auswerteschaltung (6) eine Auswertelogik zum Empfang des Abruf-Modulationssignals und zur Freigabe des beziehungsweise Umschaltung auf das Diagnosesignal(es) aufweist.

9. Sensorbaustein nach einem der Anspruch 5 bis 8, dadurch gekennzeichnet, daß das Diagnosesignal (17,17a,17b) und/oder das Abruf-Modulationssignal als analoges oder digitales Signal vorliegt.

10. Verwendung eines Sensorbausteins nach Anspruch 5 bis 9 für eine Drehzahlmessung mit gleichzeitiger Abstandmessung des Sensors (2) oder des Sensorbausteins (1) von einem Geber (9).

## Claims

1. A process for monitoring the function of a sensor component which has a sensor and at least one measuring amplifier wherein the sensor component has external connections, at least for power supply and for an output measurement signal, and wherein an additional measured variable is output via an available connection in addition to the measured variable, characterised in that the sensor component is configured as a monolithically-integrated circuit, that circuit measured values which are available within the sensor component are superimposed on the supply current and/or the supply voltage and/or the output measurement signal (16) as modulation signals, and are output via the available connection as diagnostic signals (17, 17a, 17b), and that either the internal circuit measured values are output as analogue or digital modulation and the output measured signal as a digital value, or the internal circuit measured values are output as digital modulation and the output measured signal as an analogue value.

2. A process according to claim 1, characterised in that in the case of a digital output measured signal (16), at least one measured value which is proportional to the sensor signals is recorded as a circuit measured value and is output via the available external connections as a diagnostic signal.

3. A process according to claim 1 or 2, characterised in that as circuit measured values, the offset voltage or the offset current, the temperature, filter coefficients and similar internal operating filter coefficients and similar internal operating data of the circuit are recorded and output via the available external connections as a diagnostic signal.

4. A process according to one of claims 1 to 3, characterised in that the diagnostic signal is recalled from outside via the existing external connections, especially by means of a recall modulation signal which can be supplied via the available external connections.

5. A sensor component, which is configured as a monolithically-integrated circuit and which has a sensor and at least one measurement amplifier, wherein the sensor component has external connections at least for power supply and for the output measurement signal and wherein an available connection serves to output an additional measured variable, to implement the process according to one of claims 1 to 4, characterised in that an evaluation circuit (6) is provided in the sensor component (1) which is connected to at least one internal measuring point of the circuit, that the evaluation circuit (6) is connected to a modulator (10) for modulation of the supply current and/or the supply voltage and/or the output measurement signal to output a diagnostic signal (17, 17a, 17b) formed from an internal circuit measured value via the available external connections (11) of the sensor component and that the evaluation circuit (6), and similar additional components, is an integral component part of the monolithically-integrated circuit.

6. A sensor component according to claim 5, characterised in that it has a Schmitt trigger (5), or a similar signal conditioner, disposed downstream of the measurement amplifier (3) to form a digital output measurement signal (16) and that the evaluation circuit (6) is connected to the sensor output (8) which supplies an analogue circuit measured value and/or the output (4) of the measurement amplifier (3) which is disposed downstream of the sensor (2).

7. A sensor component according to claim 5 or 6, characterised in that the evaluation circuit (6) is connected internally to an offset compensation device (12) and/or a filter (13) and/or a temperature sensor.

8. A sensor component according to one of claims 5 to 7, characterised in that the diagnosis signal (17, 17a, 17b) can be reclled from outside via the available external connections, especially by means of a recall modulation signal which can be supplied via the available external connections, and that the evaluation circuit (6) has evaluating logic for receiving the recall modulation signal and for release of, or switching to, the diagnostic signal.

9. A sensor component according to one of claims 5 to 8, characterised in that the diagnostic signal (17, 17a, 17b) and/or the recall modulation signal is present as an analogue or a digital signal.

10. The use of a sensor component according to claims 5 to 9 for rotational speed measurement with simultaneous distance measurement of the sensor (2) or the sensor component (1) from an encoder (9).

## Revendications

1. Procédé pour la surveillance du fonctionnement d'un module de détection présentant un capteur ainsi qu'au moins un amplificateur de mesure, le module de détection possédant des connexions extérieures au moins pour l'alimentation en courant et pour un signal de mesure de sortie, et une grandeur mesurée supplémentaire étant sortie par l'intermédiaire d'une connexion existante en plus de la grandeur mesurée, **caractérisé en ce que** le module de détection est formé comme un circuit intégré monolithique, en ce que des valeurs de mesure du circuit disponibles à l'intérieur du module de détection sont superposées au courant d'alimentation et/ou à la tension d'alimentation et/ou au signal de mesure de sortie (16) comme signaux de modulation, et sorties comme signaux de diagnostic (17, 17a, 17b) par l'intermédiaire des connexions extérieures existantes, et en ce que soit les valeurs internes de mesure du circuit sont sorties comme modulation analogique ou numérique et le signal de mesure de sortie comme valeur numérique, soit les valeurs internes de mesure du circuit sont sorties comme modulation numérique et le signal de mesure de sortie comme valeur analogique.

2. Procédé selon la revendication 1, **caractérisé en ce que,** en cas d'un signal de mesure de sortie numérique (16), au moins une valeur de mesure proportionnelle aux signaux du capteur est détectée comme valeur de mesure du circuit et sortie comme signal de diagnostic par l'intermédiaire des connexions extérieures existantes.

3. Procédé selon la revendication 1 ou 2, **caractérisé en ce que** la tension offset, ou le courant offset, la température, les coefficients de filtre et des données d'exploitation internes similaires du circuit sont détectés comme valeurs de mesure du circuit et sortis comme signal de diagnostic par l'intermédiaire des connexions externes existantes.

4. Procédé selon l'une des revendications 1 à 3, **caractérisé en ce que** le signal de diagnostic est appelé de l'extérieur par l'intermédiaire des connexions externes existantes, notamment au moyen d'un signal de modulation d'appel pouvant être alimenté par les connexions externes existantes.

5. Module de détection formé comme un circuit intégré monolithique et présentant un capteur ainsi qu'au moins un amplificateur de mesure, le module de détection possédant des connexions extérieures au moins pour l'alimentation en courant et pour le signal de mesure de sortie, et une connexion existante servant à sortir une grandeur mesurée supplémentaire pour l'exécution du procédé selon l'une des revendications 1 à 4, **caractérisé en ce qu**'un circuit d'évaluation (6) est prévu dans le module de détection (1), circuit qui est raccordé au moins à un point de mesure interne du circuit, en ce que le circuit d'évaluation (6) est relié à un modulateur (10) pour la modulation du courant d'alimentation et/ou de la tension d'alimentation et/ou du signal de mesure de sortie pour la sortie d'un signal de diagnostic (17, 17a, 17b) formé par une valeur de mesure du circuit interne par l'intermédiaire des connexions extérieures (11) existantes du module de détection et en ce que le circuit d'évaluation (6) et des sous-groupes supplémentaires similaires sont partie intégrante du circuit monolithique intégré.

6. Module de détection selon la revendication 5, **caractérisé en ce qu'il** présente, placé après l'amplificateur de mesure (3), un trigger de Schmitt ou un formateur de signal similaire pour la formation d'un signal de mesure de sortie (16) numérique, et en ce que le circuit d'évaluation (6) est raccordé à la sortie du capteur fournissant une valeur de mesure du circuit analogique et/ou à l'amplificateur de mesure connecté en aval.

7. Module de détection selon la revendication 5 ou 6, **caractérisé en ce que** le circuit d'évaluation (6) est raccordé à un dispositif de compensation d'offset (12) et/ou à un filtre (13) et/ou à une sonde de température par un circuit interne.

8. Module de détection selon l'une des revendications 5 à 7, **caractérisé en ce que** le signal de diagnostic (17, 17a, 17b) peut être appelé de l'extérieur par l'intermédiaire des connexions externes existantes, notamment au moyen d'un signal de modulation d'appel pouvant être alimenté par les connexions externes existantes, et en ce que le circuit d'évaluation (6) présente une logique d'évaluation pour la réception du signal de modulation d'appel et pour la libération du signal de diagnostic ou la commutation sur le signal de diagnostic.

9. Module de détection selon l'une des revendications 5 à 8, **caractérisé en ce que** le signal de diagnostic (17, 17a, 17b) et/ou le signal de modulation d'appel est disponible comme signal analogique ou numérique.

10. Utilisation d'un module de détection selon les revendications 5 à 9 pour le comptage du nombre de tours, avec, en même temps, mesure de la distance entre le capteur (2) ou le module de détection (1) et un transmetteur (9).
